(19) Europäisches Patentamt
European Patent Office
Office européen des brevets

(11) Veröffentlichungsnummer: **0 259 728**
**A2**

(12) # EUROPÄISCHE PATENTANMELDUNG

(21) Anmeldenummer: **87112573.8**

(22) Anmeldetag: **28.08.87**

(51) Int. Cl.⁴: **C08K 5/32**, C08J 3/08, C08L 63/00, C08L 61/00, C08L 71/00

(30) Priorität: **11.09.86 DE 3630993**

(43) Veröffentlichungstag der Anmeldung: **16.03.88 Patentblatt 88/11**

(84) Benannte Vertragsstaaten: **AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Ahne, Hellmut, Dr.**
**Heidestrasse 6**
**D-8551 Röttenbach(DE)**
Erfinder: **Plundrich, Winfried**
**Stahlstrasse 13**
**D-8500 Nürnberg(DE)**

(54) **Stabilisierte Lösungen von Photopolymeren.**

(57) Lösungen von Photopolymeren auf der Basis von Polyethern, Epoxidharzen, Phenol-Formaldehyd-Harzen und Amino-Phenolharzen weisen dann eine hohe Lagerstabilität auf, wenn sie als Stabilisator N-Nitrosodiphenylamin oder Derivate davon enthalten. In diesem Fall unterliegen die Lösungen nämlich keiner Gelierung.

EP 0 259 728 A2

## Stabilisierte Lösungen von Photopolymeren

Die Erfindung betrifft stabilisierte Lösungen von Photopolymeren auf der Basis von Polyethern, Epoxidharzen, Phenol-Formaldehyd-Harzen und Amino-Phenolharzen.

Photopolymere sind photoreaktive bzw. photovernetzbare Poly-mere, d.h. Polymere, die durch Bestrahlen (einer Schicht des Polymeren) mit aktinischem Licht, wie UV-Licht, vernetzt und dadurch in Polymere mit hoher Wärmeformbeständigkeit übergeführt werden können. Photopolymere werden deshalb beispielsweise in der Feinstleitertechnik als Lötstopp-und Isolierlack verwendet. Die Photopolymeren werden dazu in Form einer Lösung als Schicht auf entsprechende Substrate aufgetragen, dann wird getrocknet und anschließend bestrahlt.

Photopolymere auf der Basis von Polyethern sind beispielsweise aus der DE-OS 25 03 526 bekannt. Dabei handelt es sich um 3-(2-Furyl)-acrylsäureester von Phenoxyharzen mit einem Molekulargewicht von wenigstens etwa 15000. Diese Photopolymeren werden im graphischen Gewerbe, insbesondere für lithographische Druckplatten und Ätzresists, verwendet. Photopolymere auf Epoxidharzbasis sind beispielsweise aus "Chimia", Bd. 38 (1984), Seiten 13 bis 20) bekannt. Diese Photopolymeren weisen Epoxidendgruppen auf, während in der Polymerkette lichtempfindliche Chalkongruppen angeordnet sind, d.h. Gruppen folgender Struktur: $-C_6H_4-CH=CH-CO-C_6H_4-$. Diese Photopolymeren können als Galvanoresist oder als Lötstopplack eingesetzt werden.

Für den technischen Einsatz von Photopolymeren, beispielsweise zur Erzeugung strukturierter, lötbadresistenter Schutz-und Isolierschichten, ist, insbesondere bei größeren Mengen, eine ausreichende Lagerstabilität der gebrauchsfertigen Lösungen Voraussetzung. Diese kann bisher jedoch nicht mit ausreichender Sicherheit gewährleistet werden, sie unterliegt darüber hinaus großen Schwankungen.

Die mangelnde Lagerbeständigkeit bzw. -stabilität von Photopolymerlösungen äußert sich in einer Erhöhung der Viskosität. Diese Viskositätserhöhung bzw. -zunahme führt im Laufe der Zeit sogar zum Gelieren, so daß die Lösungen nicht mehr gebrauchsfähig sind. Die Ursache für die Viskositätserhöhung dürfte in einer vorzeitig einsetzenden, nicht-strahlungsinduzierten Vernetzung der photoreaktiven Gruppen der Photopolymeren zu sehen sein. Dies würde auch erklären, warum die Viskositätserhöhung irreversibel ist.

Aufgabe der Erfindung ist es, die Lagerstabilität von Lösungen von Photopolymeren der eingangs genannten Art zu erhöhen, d.h. diese Lösungen wirksam gegen ein Gelieren zu stabilisieren, bzw. für die Stabilisierung der Lösungen geeignete Stabilisatoren bereitzustellen.

Dies wird erfindungsgemäß dadurch erreicht, daß die Lösungen als Stabilisatoren N-Nitrosodiphenylamine folgender Struktur enthalten:

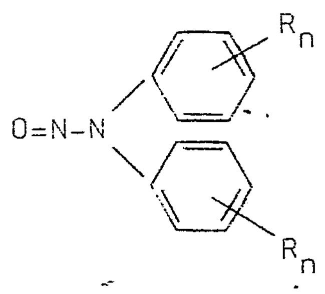

,

wobei folgendes gilt:

R = Wasserstoff, Halogen, eine Alkylgruppe mit 1 bis 3 Kohlenstoffatomen, eine Phenylgruppe oder eine Tolylgruppe;

n = 1 bis 5, mit der Maßgabe, daß jeder der beiden aromatischen Reste maximal eine Phenyl-bzw. Tolylgruppe aufweist.

Gegenstand der Erfindung sind somit stabilisierte Lösungen von Photopolymeren auf der Basis von Polyethern, Epoxidharzen, Phenol-Formaldehyd-Harzen und Amino-Phenolharzen, welche N-Nitrosodiphenylaminverbindungen der vorstehend genannten Struktur als Stabilisatoren enthalten.

Gegenstand der Erfindung ist ferner die Verwendung von N-Nitrosodiphenylaminverbindungen der genannten Art zur Erhöhung der Lagerstabilität von Lösungen von Photopolymeren auf der Basis von Polyethern, Epoxidharzen, Phenol-Formaldehyd-Harzen und Amino-Phenolharzen, d.h. zur Stabilisierung gegen ein Gelieren durch vorzeitige, nicht-strahlungsinduzierte Vernetzung.

Es hat sich nämlich überraschenderweise gezeigt, daß sich beim Zusatz der N-Nitrosodiphenylaminverbindungen zu Lösungen von Photopolymeren der genannten Art sowohl das Problem der Schwankung der Lagerbeständigkeit beseitigen läßt als auch die Lagerstabilität allgemein beträchtlich erhöht wird. Gebrauchsfertige Lösungen, die erfindungsgemäß stabilisiert sind, weisen nämlich eine Lagerbeständigkeit bis zu einem Jahr auf (bei Raumtemperatur), d.h. innerhalb dieses Zeitraumes bleibt die Viskosität der Lösungen konstant. Die Photopolymerlösungen sind somit praktisch beliebig lange lager-und gebrauchsfähig, was insbesondere für die Bevorratung größerer Mengen, wie sie beispielsweise beim Einsatz der Photopolymeren als Lötstopplack erforderlich sind, von entscheidender wirtschaftlicher und technischer Bedeutung ist. Ein weiterer wesentlicher Vorteil ist, daß durch die Zugabe der erfindungsgemäßen Stabilisatoren die Photoempfindlichkeit der Photopolymeren bzw. Photopolymerlösungen nicht beeinträchtigt wird.

Der Gehalt der Photopolymerlösungen an Stabilisator liegt im allgemeinen etwa zwischen 0,01 und 2 Gew.-%, bezogen auf das Festharz, d.h. auf das Photopolymere; im Bedarfsfall kann der Gehalt auch höher liegen und bis zu ca. 5 Gew.-% betragen. Vorzugsweise enthalten die Lösungen jedoch zwischen 0,05 und 1 Gew.-% an Stabilisator. Dabei kann jeweils entweder nur eine einzige N-Nitrosodiphenylaminoverbindung eingesetzt werden oder ein Gemisch verschiedener derartiger Verbindungen. Bevorzugt finden dabei N-Nitrosodiphenylamin sowie dessen Methyl-, Fluor-und Bromderivate Verwendung.

Die Photopolymeren gelangen als Lösung in organischen Lösungsmitteln zum Einsatz. Dazu werden vorteilhaft polare Lösungsmittel verwendet. Bevorzugte Lösungsmittel sind dabei die folgenden: γ-Butyrolacton, Cyclohexanon, Dimethylacetamid, Dimethylformamid, Glykoldimethylether, Methoxypropylacetat und N-Methylpyrrolidon sowie Gemische dieser Lösungsmittel.

Der Gehalt der Lösungen an Feststoff, d.h. an Photopolymer, beträgt im allgemeinen etwa zwischen 10 und 50 Gew.-%. Den Photopolymerlösungen können auch photoreaktive Additive, d.h. licht-oder strahlungsempfindliche copolymerisationsfähige Verbindungen, sowie Photoinitiatoren und/oder Photosensibilisatoren zugesetzt werden. Additive der genannten Art sind beispielsweise acrylat-und methacrylatgruppenhaltige Verbindungen, als Photoinitiatoren bzw. -sensibilisatoren kommen α-Halogenacetophenone, Dialkoxyacetophenone, Benzoylphosphinoxide und Michler's Keton in Betracht. Den Lösungen können ferner auch mineralische Füllstoffe, insbesondere auf Siliciumdioxid-und Aluminiumoxidbasis, sowie auch weitere, üblicherweise eingesetzte Füllstoffe zugegeben werden.

Die erfindungsgemäß stabilisierten Lösungen enthalten Photopolymere auf der Basis von Polyethern, Epoxidharzen, Phenol-Formaldehyd-Harzen und Amino-Phenolharzen. Dabei kommen insbesondere solche Photopolymere in Betracht, bei denen die photoreaktiven Gruppen, welche eine olefinisch ungesättigte Struktur aufweisen, über Urethan-oder Harnstoffbrücken an das Basispolymer gebunden sind. Die Urethan- bzw. Harnstoffbrücken werden dabei durch Addition von olefinisch ungesättigten Monoisocyanaten an die Hydroxyl-bzw. Aminogruppen von hydroxylgruppenhaltigen Polyethern, hydroxylgruppenhaltigen Epoxiden, Phenol-Formaldehyd-Harzen und Amino-Phenolharzen gebildet.

Photopolymere auf Polyetherbasis sind beispielsweise Gegenstand der europäischen Patentanmeldung mit der Veröffentlichungsnummer 0 206 158. Diese photoreaktiven Polyether weisen im allgemeinen folgende Struktur auf:

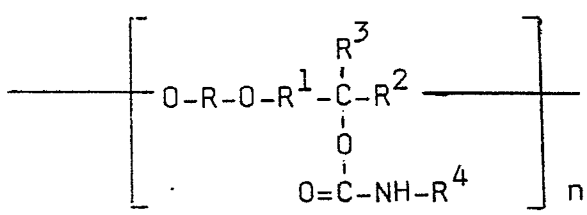

Dabei ist n ≥ 50.

Für R, $R^1$, $R^2$, $R^3$ und $R^4$ gilt folgendes:

R ist ein - gegebenenfalls halogenierter - divalenter, d.h. difunktioneller Rest aromatischer und/oder aliphatischer und/oder cycloaliphatischer, gegebenenfalls Heteroatome aufweisender, und/oder heterocyclischer Struktur;

$R^1$ ist ein divalenter aliphatischer Rest;

$R^2$ ist ein - gegebenenfalls halogensubstituierter - divalenter aliphatischer und/oder cycloaliphatischer Rest;

$R^3$ ist Wasserstoff oder eine - gegebenenfalls halogensubstituierte - Alkylgruppe;

$R^4$ ist eine über eine aliphatische und/oder cycloalipha tische und/oder aromatische Brücke gebundene olefinisch ungesättigte Gruppe, beispielsweise eine allylether-oder maleinimidhaltige Gruppe und insbesondere eine - gegebenenfalls substituierte - (meth)acrylesterhaltige Gruppe.

Die photoreaktiven Epoxidharze weisen im allgemeinen folgende Struktur auf:

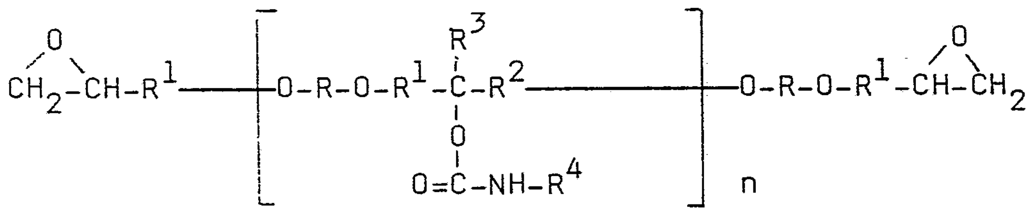

Dabei liegt n zwischen 1 und 20; R, $R^1$, $R^2$, $R^3$ und $R^4$ sind wie vorstehend definiert.

Die photoreaktiven Phenol-Formaldehyd-Harze weisen im allgemeinen folgende Struktur auf:

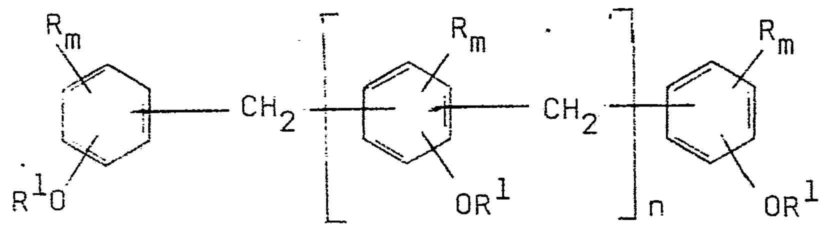

Dabei ist n = 1 bis 10 und m = 1 bis 3.

Für R und $R^1$ gilt folgendes:

R ist Wasserstoff, Halogen oder eine Alkylgruppe;

$R^1$ ist Wasserstoff oder $-\underset{\underset{O}{\|}}{C}-NH-R^2$,

wobei aber nicht alle Reste $R^1$ gleichzeitig Wasserstoff sein können;

$R^2$ ist dabei eine über eine aliphatische und/oder cyclo aliphatische und/oder aromatische Brücke gebundene olefinisch ungesättigte Gruppe, beispielsweise eine allylether-oder maleinimidhaltige Gruppe und insbesondere eine - gegebenenfalls substituierte - (meth)acrylesterhaltige Gruppe.

Die photoreaktiven Amino-Phenolharze weisen im allgemeinen folgende Struktur auf:

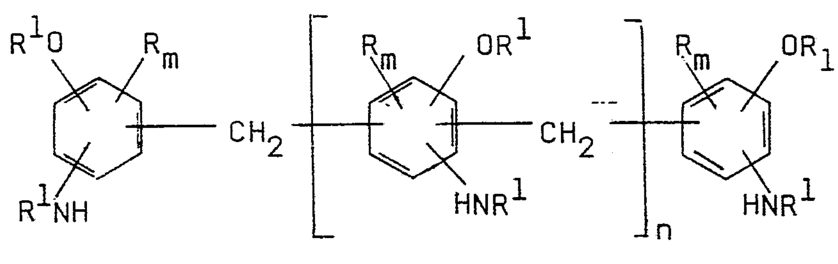

Dabei ist n = 2 bis 15 und m = 1 oder 2.

Für R und $R^1$ gilt folgendes:

R ist Wasserstoff, Halogen oder eine Alkylgruppe;

$R^1$ ist Wasserstoff oder $-\underset{\underset{O}{\|}}{C}-NH-R^2$,

wobei die an N gebundenen Reste $R^1$ aber nicht alle gleichzeitig Wasserstoff sein können;

$R^2$ ist dabei eine über eine aliphatische und/oder cycloaliphatische und/oder aromatische Brücke gebundene olefinisch ungesättigte Gruppe, beispielsweise eine allylether-oder maleinimidhaltige Gruppe und insbesondere eine - gegebenenfalls substituierte - (meth)acrylesterhaltige Gruppe.

Die Verwendung von Lösungen von Photopolymeren auf Polyetherbasis ist beispielsweise Gegenstand der europäischen Patentanmeldung mit der Veröffentlichungsnummer 0 206 159.

Anhand von Ausführungsbeispielen soll die Erfindung noch näher erläutert werden.

Beispiel 1

(Photopolymer auf Polyetherbasis)

Zu einer Lösung von 110 Masseteilen des Phenoxyharzes Rütapox 0723 (50 %ige Lösung in Cyclohexanon/Ethylglykolacetat; Rütapox® ist ein Warenzeichen der Fa. Rütgerswerke AG) in 114 Masseteilen γ-Butyrolacton werden 33 Masseteile reines Isocyanatoethylmethacrylat und 0,1 Masseteile Dibutylzinndilaurat gegeben, dann wird das Gemisch bei Raumtemperatur 30 Stunden gerührt. Danach werden zur Reaktionslösung 9 Masseteile 2-Hydroxyethylmethacrylat gegeben. Nach weiteren 30 Stunden werden 100 Masseteilen der Harzlösung 0,6 Masseteile Dichloracetophenon, 0,3 Masseteile Diethoxyacetophenon, 0,3 Masseteile Michler's Keton, 0,3 Masseteile Vinyl-tris(β-methoxyethoxy)-silan und 0,1 Masseteile N-Nitrosodiphenylamin zugesetzt. Nachfolgend wird die Lösung durch ein 5 μm-Filter druckfiltriert. Die Lösung weist bei Raumtemperatur eine Lagerstabilität von über 6 Monaten auf, d.h. die Viskosität der Lösung bleibt konstant (ca. 500 mPa.s bei 23°C).

Die filtrierte Lösung des photoreaktiven Phenoxyharzes wird bei 400 Umdrehungen/Minute auf eine Leiterplatten-Testplatte mit Kupfer-Leiterbahnen auf der Oberfläche geschleudert und danach 1/2 Stunde bei 70°C im Umluftofen getrocknet. Die Dicke der Lackschicht beträgt dann 50 μm. Nach Belichtung mit einer 350 W-Quecksilberhöchstdrucklampe durch eine Maske für 10 s und nach 30minütigem Nachtrocknen bei 70°C im Umluftofen werden mit Cyclohexanon als Entwickler, wobei Wasser als Stopper verwendet wird, nach 35 s kantenscharfe strukturierte Schichten erhalten, die in ihrer Oberflächenqualität auch durch hundertmaliges Cyceln zwischen -65° und +125°C nicht beeinträchtigt werden. Diese Schichten widerstehen ebenso unbeschadet Schwall-und Tauchlötprozessen bei 260°C; das Lot perlt von der Oberfläche ab. Feuchtetests bei 40°C und 92 % Luftfeuchte und unter einer Spannung von 100 V zeigen keine Korrosion in den mit Lack abgedeckten Leiterbahnbereichen. Durch den zugesetzten Stabilisator werden somit die Eigenschaften des photoreaktiven Polyethers, insbesondere dessen Photoempfindlichkeit, nicht nachteilig beeinflußt.

Beispiel 2

(Photopolymer auf Epoxidharzbasis)

Zu 69 Masseteilen getrocknetes Dichlormethan werden unter Feuchteausschluß 40 Masseteile reines 2.4-Diisocyanatotoluol und zu der dabei erhaltenen Lösung dann bei Raumtemperatur unter Rühren langsam 29,2 Masseteile 2-Hydroxyethylacrylat getropft. Nach 24stündigem Stehen wird durch Titration der Isocyanatgruppen ein 99 %iger Umsatz ermittelt. Das photoreaktive Isocyanat wird mit 250 Masseteilen Petroleumbenzin aus der Reaktionslösung extrahiert und nach Entfernen des Extraktionsmittels als klare viskose Flüssigkeit isoliert; Ausbeute: 64,5 g, d.h. 93 % der Theorie.

Zu einer Lösung von 100 Masseteilen des Epoxidharzes Araldit GT 6099 (Araldit® ist ein Warenzeichen der Fa. Ciba-Geigy AG) werden bei Raumtemperatur und unter Rühren 366 Masseteile trockenes γ-Butyrolacton, 353 Masseteile trockenes N-Methylpyrrolidon, 131 Masseteile des in der vorstehend beschriebenen Weise isolierten reinen photoreaktiven Monoisocyanats und 0,3 Masseteile Dibutylzinndilaurat gegeben. Nachdem das Gemisch 48 Stunden gerührt wurde, werden zur Reaktionslösung Masseteile Ethanol gegeben. Nach weiteren 24 Stunden sind keine Isocyanatgruppen mehr nachweisbar.

Zu 100 Masseteilen des in der vorstehend beschriebenen Weise - als 23 %ige Harzlösung - hergestellten photoreaktiven Epoxidharzes werden 0,65 Masseteile Benzoinisopropylether, 0,22 Masseteile Michler's Keton, 1,65 Masseteile Trimethylolpropantriacrylat, 0,3 Masseteile Vinyl-tris(β-methoxyethoxy)-silan, 0,2 Masseteile 2-Isopropylimidazol (als Härter) und 0,15 Masseteile N-Nitrosodiphenylamin gegeben. Die Lösung wird dann durch ein 5 μm-Filter druckfiltriert. Die Viskosität der dabei erhaltenen Lösung beträgt ca. 300 mPa.s bei 23°C und weist - bei Raumtemperatur - eine Lagerstabilität von mehr als 6 Monaten auf.

Durch Aufschleudern der Lösung bei ca. 500 Umdrehungen/Minute auf eine mit einem Haftvermittler beschichtete Siliciumscheibe werden nach 30minütigem Trocknen bei 70°C in einem Umluftofen 23 μm dicke homogene Schichten erhalten, die nach einer Belichtung von 40 s mit einer 350 W-Quecksilberhöchstdrucklampe durch eine Maske mit γ-Butyrolacton/Xylol (Volumenverhältnis 1:2) und Nachspülen mit Xylol im Sprühverfahren zu konturenscharfen strukturierten Schichten entwickelt werden. Die Kantenausbildung und die Oberflächenqualität dieser Schichten werden durch einstündiges Tempern bei 150°C nicht beeinträchtigt. Die aufgelösten Strukturen liegen bei ≤20 μm.

Beispiel 3

(Photopolymer auf Phenol-Formaldehyd-Harzbasis)

Zu einer Lösung von 51,6 Masseteilen des Novolakharzes Bakelite LG 724 (Bakelite® ist ein Warenzeichen der Fa. Bakelite GmbH) in 80 Masseteilen Cyclohexanon werden 41,4 Masseteile reines Isocyanatoethylmethacrylat und 0,1 Masseteile Dibutylzinndilaurat gegeben, dann wird das Gemisch bei Raumtemperatur 48 Stunden gerührt. Danach werden 100 Masseteilen der Harzlösung 0,5 Masseteile Dichloracetophenon, 1,5 Masseteile Diethoxyacetophenon, 0,5 Masseteile Michler's Keton, 0,5 Masseteile Vinyl-tris($\beta$-methoxyethoxy)-silan und 0,15 Masseteile N-Nitrosodiphenylamin zugesetzt. Nachfolgend wird die Lösung durch ein 5 $\mu$m-Filter druckfiltriert. Die Lagerbeständigkeit dieser Lösung beträgt bei Raumtemperatur mehr als 5 Monate.

## Ansprüche

1. Stabilisierte Lösungen von Photopolymeren auf der Basis von Polyethern, Epoxidharzen, Phenol-Formaldehyd-Harzen und Amino-Phenolharzen, **dadurch gekennzeichnet,** daß sie als Stabilisatoren N-Nitrosodiphenylamine folgender Struktur enthalten:

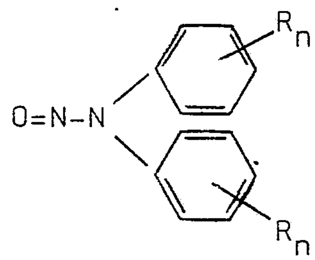
,

wobei folgendes gilt:
R = Wasserstoff, Halogen, eine Alkylgruppe mit 1 bis 3 Kohlenstoffatomen, eine Phenylgruppe oder eine Tolylgruppe;
n = 1 bis 5, mit der Maßgabe, daß jeder der beiden aromatischen Reste maximal eine Phenyl-bzw. Tolylgruppe aufweist.

2. Stabilisierte Lösungen nach Anspruch 1, **dadurch gekennzeichnet,** daß sie N-Nitrosodiphenylamin oder ein Methyl-, Fluor-oder Bromderivat enthalten.

3. Stabilisierte Lösungen nach Anspruch 1 oder 2, **dadurch gekennzeichnet,** daß sie 0,01 bis 2 Gew.-% an Stabilisator enthalten, bezogen auf das Festharz.

4. Stabilisierte Lösungen nach Anspruch 3, **dadurch gekennzeichnet,** daß sie 0,05 bis 1 Gew.-% an Stabilisator enthalten.

5. Stabilisierte Lösungen nach einem der Ansprüche 1 bis 4, **dadurch gekennzeichnet,** daß das Lösungsmittel ein polares organisches Lösungsmittel ist.

6. Verwendung von N-Nitrosodiphenylaminen folgender Struktur:

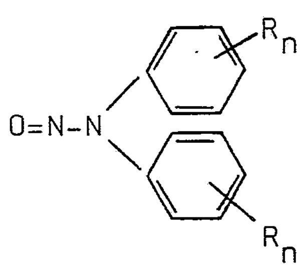
,

wobei folgendes gilt:
R = Wasserstoff, Halogen, eine Alkylgruppe mit 1 bis 3 Kohlenstoffatomen, eine Phenylgruppe oder eine Tolylgruppe;
n = 1 bis 5, mit der Maßgabe, daß jeder der beiden aromatischen Reste maximal eine Phenyl-bzw. Tolylgruppe aufweist,

zur Erhöhung der Lagerstabilität von Lösungen von Photopolymeren auf der Basis von Polyethern, Epoxidharzen, Phenol-Formaldehyd-Harzen und Amino-Phenolharzen.